# FASCICULE DE BREVET EUROPEEN

(11) **EP 1 268 884 B1**
(45) Date de publication et mention de la délivrance du brevet: **29.07.2009**
(21) Numéro de dépôt: 01919609.6
(22) Date de dépôt: 02.04.2001
(51) Int. Cl.: C30B 31/22, C30B 33/00, H01L 21/762

(54) **PROCEDE ET DISPOSITIF DE FABRICATION DE SUBSTRATS**
VERFAHREN UND VORRICHTUNG ZUR HERSTELLUNG VON SUBSTRATEN
METHOD AND DEVICE FOR MAKING SUBSTRATES

(30) Priorité: 03.04.2000 FR 0004210
(43) Date de publication de la demande: 02.01.2003
(73) Titulaire: S.O.I.Tec Silicon on Insulator Technologies, 38190 Bernin (FR)
(72) Inventeur: IWASAKI, Atsushi, Tokyo 112-0001 (JP); GHYSELEN, Bruno, F-38170 Seyssinet (FR)
(74) Mandataire: Le Forestier, Eric
(86) Numéro de dépôt international: PCT/FR2001/000976
(87) Numéro de publication internationale: WO 2001/075196

(56) Documents cités:
- EP-A- 0 851 465
- WO-A-00/61841
- WO-A-99/41779
- DE-A- 2 427 645
- FR-A- 2 752 768
- FR-A- 2 774 510
- US-A- 5 877 070
- PATENT ABSTRACTS OF JAPAN vol. 1998, no. 09, 31 juillet 1998 (1998-07-31) & JP 10 093122 A (NIPPON TELEGR &TELEPH CORP <NTT>), 10 avril 1998 (1998-04-10)
- WELDON M K ET AL: "MECHANISM OF SILICON EXFOLIATION BY HYDROGEN IMPLANTATION AND HE, LI AND CO-IMPLANTATION" IEEE INTERNATIONAL SOI CONFERENCE,US,NEW YORK, NY: IEEE, vol. CONF. 23, 6 octobre 1997 (1997-10-06), pages 124-125, XP000801871 ISBN: 0-7803-3939-8
- BEHR D ET AL: "Lift-off technique of homoepitaxial CVD diamond films by deep implantation and selective etching" DIAMOND AND RELATED MATERIALS,NL,ELSEVIER SCIENCE PUBLISHERS, AMSTERDAM, vol. 6, no. 5-7, 1 avril 1997 (1997-04-01), pages 654-657, XP004081116 ISSN: 0925-9635

## Description

L'invention concerne le domaine de la fabrication de substrats, notamment pour l'optique, l'électronique ou l'optoélectronique.

En général, on obtient industriellement, des substrats utilisables dans les domaines précités en découpant des lingots. Dans le cas du silicium monocristallin, par exemple, ces lingots sont obtenus par la méthode de tirage Czochralski (tirage CZ) à partir d'un bain de silicium fondu ou par la méthode de fusion de zone (tirage FZ) à partir d'un lingot polycristallin. Ces méthodes de croissance fournissent des lingots de forme cylindrique qui sont ensuite découpés en tranches perpendiculaires à l'axe du cylindre, généralement à l'aide d'une scie circulaire à coupe interne.

Mais ces méthodes ne permettent pas d'obtenir des substrats de dimensions satisfaisantes pour certaines applications. C'est le cas notamment dans le domaine particulier de la fabrication de substrats de grandes dimensions, susceptibles d'être utilisés, par exemple, pour la réalisation d'écrans de visualisation, plats ou non, ou de cellules solaires.

Pour obtenir des substrats de silicium monocristallin de plus grande dimension, il a été proposé par le document FR 2 752 768 de procéder à des découpes de lingots parallèlement à leur axe longitudinal.

Un but de l'invention est de proposer encore une autre forme de fabrication de substrats à partir de lingots.

Un autre but de l'invention est d'obtenir des substrats d'un matériau monocristallin, par exemple de silicium monocristallin, avec des coûts de production plus faibles qu'avec les procédés de l'art antérieur.

Ce but est atteint grâce à un procédé de fabrication de substrats, notamment pour l'optique, l'électronique ou l'optoélectronique selon la revendication 1.

Ainsi, grâce à l'invention on obtient un substrat en pelant la couche de la surface du lingot, parallèle à l'axe du cylindre qui le constitue.

Il faut comprendre que le terme « substrat » est utilisé partout dans ce texte pour désigner aussi bien un élément de matériau susceptible de servir de support à un autre élément, qu'un film ou une couche, mince ou non, rigide ou non, etc., c'est à dire au sens le plus général du terme.

Il faut également comprendre les termes « cylindre » et cylindrique », dans leur sens premier. A savoir que, dans ce sens , un cylindre désigne un solide engendré par une droite qui se déplace parallèlement à elle même en s'appuyant sur une courbe. Dans ce texte, un cylindre peut donc avoir une section ronde comme une section polygonale.

Avantageusement, le procédé selon l'invention permet une fabrication continue de substrats.

Du fait que le procédé selon l'invention autorise une mise en oeuvre en continue, il permet d'accroître la productivité de la fabrication de substrats et donc de réduire les coûts de production. Ce procédé est particulièrement intéressant, par exemple, lorsque l'on souhaite fabriquer des substrats de silicium monocristallin, à faible coût.

Le document WO 99/41779, le plus proche de l'invention dans l'art antérieur, décrit un procédé pour détacher un film d'une structure cristalline comprenant une implantation d'ions dans la structure de cristal pour fragiliser une couche superficielle et le pelage de cette couche superficielle.

Le procédé selon l'invention présente les caractéristiques avantageuses suivantes, prises indépendamment ou en combinaison :
- l'implantation des espèces atomiques est réalisée en bombardant en continu la surface cylindrique du lingot, avec un balayage, dans la direction longitudinale du lingot, avec un faisceau ponctuel, tandis que l'on fait tourner ce lingot autour d'un axe parallèle à sa surface cylindrique;
- l'implantation des espèces atomiques est réalisée en bombardant en continu la surface cylindrique du lingot, avec un faisceau de section allongée correspondant à une aire donnée, tandis que l'on fait tourner ce dernier autour d'un axe parallèle à cette surface cylindrique ;
- l'implantation des espèces atomiques est réalisée par des bombardements successifs avec un faisceau correspondant à une aire donnée, de zones adjacentes de la surface cylindrique du lingot, en faisant tourner le lingot autour d'un axe parallèle à cette surface cylindrique du lingot, entre chaque bombardement ;
- l'implantation des espèces atomiques est réalisée en bombardant en continu la totalité de la surface cylindrique du lingot, par exemple en immergeant le lingot dans un plasma ;
- il comprend en outre, une opération de chauffage de la surface cylindrique ; cette opération de chauffage peut être réalisée avant, pendant ou après l'implantation ; cette opération de chauffage peut être réalisée par l'implantation elle-même ; cette opération de chauffage permet de réduire la dose d'espèces atomiques implantées nécessaire et/ou de favoriser une guérison in situ de certains défauts d'implantation ;
- il comporte une opération consistant à transférer la couche de matériau située entre la surface cylindrique du lingot et la profondeur de décollement, sur un support ;
- il comporte une opération consistant à presser la couche de matériau située entre la surface cylindrique du lingot et la profondeur de décollement, grâce à un rouleau ; cette opération de pression permet de provoquer un choc thermique si ce rouleau est refroidissant, ou de chauffer le lingot, s'il est chauffant, et/ou d'imposer des contraintes mécaniques de pression et/ou de cisaillement pour favoriser et/ou provoquer le détachement du lingot et de la couche de matériau située entre la surface cylindrique du lingot et la profondeur de décollement ;
- le support est adhésif ;
- il comporte une opération consistant à recouvrir la couche de matériau située entre la surface cylindrique du lingot et la profondeur de décollement par un dépôt en phase liquide ou un dépôt en phase gazeuse ;
- le matériau est du silicium ;
- les espèces atomiques comprennent des ions hydrogène ;
- les espèces atomiques comprennent des ions de dopage tels que du phosphore, de l'arsenic ou du bore ;
- il comporte des opérations consistant à reporter par laminage entre des rouleaux, une couche sur une des faces de la couche de matériau située entre la surface cylindrique du lingot et la profondeur de décollement, sur l'autre de ces faces, ou sur les deux ;
- il comporte une opération consistant à reporter au moins une couche comprenant des motifs de circuiterie, sur la couche de matériau située entre la surface cylindrique du lingot et la profondeur de décollement.
   Pour la fabrication d'écrans de visualisation et de cellules solaires en particulier, le silicium amorphe ou polycristallin déposé sur un substrat de verre est souvent utilisé, car le dépôt de silicium monocristallin sur verre, sur quartz, etc., n'est possible à ce jour que par des techniques de transfert de couches en utilisant un substrat de silicium monocristallin pour réaliser la couche qui sera transférée sur le substrat de verre. Or les substrats de silicium monocristallin sont aujourd'hui limités à 200 voire 300 mm de diamètre.
   Grâce au procédé selon l'invention, il est possible de fabriquer des substrats de silicium monocristallin de plus grandes dimensions. Même si les substrats de silicium monocristallin obtenus selon certaines variantes du procédé selon l'invention, ne présentent pas une orientation cristalline parfaite, ils présentent des qualités supérieures à celles du silicium amorphe ou polycristallin. Ainsi, lorsqu'ils sont utilisés pour la réalisation d'écrans plats, ils permettent d'obtenir un gain pour la densité d'intégration (nombre de pixels par unité de surface), la vitesse de rafraîchissement des écrans, etc. Lorsqu'ils sont utilisés pour la réalisation de cellules solaires, ils permettent d'obtenir une amélioration du rendement de conversion photoélectrique.
   De plus, que les substrats soient de petites ou de grandes dimensions, le fait que le procédé de fabrication de ces substrats puisse être mis en oeuvre de manière continue, permet de réduire le coût de ces substrats.
   On remarquera que le diamètre initial du lingot est peu important, alors que sa longueur l'est davantage. Or, en général, plus un lingot est d'un gros diamètre, plus il est court. Ainsi, selon les applications recherchées, on préférera utiliser un lingot de plus petit diamètre, car il est plus facile à obtenir en longueur plus importante. Mais, la couche réalisée grâce au procédé selon l'invention est développée à partir de la surface cylindrique d'un lingot. Selon certains modes de mise en oeuvre du procédé selon l'invention, ceci peut conférer initialement à cette couche une courbure qui peut s'avérer critique dans certaines circonstances. Par exemple, lorsque l'on veut stocker la couche sur un cylindre en inversant cette courbure, il peut se produire des contraintes mécaniques dommageables à la qualité de la couche, voire susceptibles d'en entraîner la rupture. Or, lorsque le diamètre du lingot augmente, ces problèmes de courbure peuvent être réduits.
   On peut également avoir intérêt à utiliser des lingots de gros diamètre, si l'on veut réduire la périodicité, dans la couche produite, de la variation de son orientation cristalline, selon la direction de son déroulement.
   Par ailleurs, les problèmes de courbure et d'orientation cristallographique évoqués ci-dessus sont considérablement réduits, voire inexistants, lorsque l'on met en oeuvre le procédé selon l'invention avec des lingots de section carrée, par exemple. Dans ce cas, en effet, la couche réalisée avec le procédé selon l'invention provient de faces planes dont l'orientation cristallographique est bien définie.
   Typiquement, un lingot de 200 mm de diamètre fait 1,5 m de longueur. Généralement, avant d'être utilisés dans le procédé selon l'invention, de tels lingots sont découpés en tronçons de 40 à 50 cm de long.
   De plus, un lingot brut de tirage a une forme extérieure mal définie (ondulation du diamètre, etc.). Au cours d'une étape précoce dans le procédé selon l'invention, une opération de tournage ou d'usinage de lingot est réalisée pour en faire respectivement un cylindre régulier ou un lingot à section polygonale. Cette opération de tournage ou d'usinage est réalisée avant ou après les opérations de découpe précitées.
   Avec des lingots de silicium, on obtient des couches de l'ordre de 10 µm, en implantant des ions hydrogène avec des énergies voisines de l'ordre du MeV. Cependant, l'essentiel est d'avoir une masse de matériau suffisamment rigide entre la profondeur de décollement et la surface du lingot pour éviter les problèmes liés à la fragilité et la déformabilité des couches.
   Avantageusement, la profondeur de décollement est déterminée pour que les couches continues formées par le procédé selon l'invention soient autoportées. Selon une variante avantageuse du procédé selon l'invention, la couche est renforcée, pour éviter les problèmes liés à sa fragilité ou sa déformabilité, par le dépôt d'un film avant l'opération de détachement ou même, lorsqu'elle existe, avant l'opération de chauffage, voire avant l'opération d'implantation. Cette variante est particulièrement avantageuse lorsque l'on veut fabriquer des couches trop minces pour être autoportées. Dans le cas du silicium par exemple, un dépôt de 10 µm de SiO₂ s'avère suffisant pour renforcer la tenue mécanique de la couche formée (un autre matériau que SiO₂ peut également être utilisé). D'une manière générale, et donc pas seulement pour des applications du procédé selon l'invention à la fabrication de couches de silicium, des dépôts de type épitaxie, pulvérisation, peinture, spray, etc., peuvent aussi être envisagés. Avantageusement également, les doses des espèces atomiques implantées sont de l'ordre de 10¹⁷ à 10¹⁸ / cm². Avec de telles doses et une profondeur de pénétration de l'ordre d'une à plusieurs dizaines de microns, il est possible d'obtenir un détachement de la couche de matériau située entre la surface et la profondeur de décollement, du reste du lingot, sans opération supplémentaire de chauffage et avec une application de contraintes limitée voire nulle.
   D'une manière générale, si une application de contraintes est opérée sur la couche, elle correspond avantageusement à l'application de contraintes mécaniques (cisaillement, traction, compression, ultrasons, etc.), de contraintes électriques (application d'un champ électrostatique ou électromagnétique), de contraintes thermiques (radiation, convection, conduction, etc.), etc. Cela peut consister également à diriger un jet de fluide (liquide ou gazeux) continu ou temporellement variable, au niveau de l'interface de décollement couche/lingot. Les contraintes thermiques en particulier peuvent dériver de l'application d'un champ électromagnétique, d'un faisceau d'électrons, d'un chauffage thermoélectrique, d'un fluide cryogénique, d'un liquide super-refroidi, etc.
   Selon un autre aspect, l'invention est un dispositif de fabrication de substrats, notamment pour l'optique, l'électronique ou l'optoélectronique, caractérisé par le fait qu'il comporte
- des moyens d'implantation d'espèces atomiques sous la surface d'un matériau sous forme d'un lingot cylindrique, à une profondeur d'implantation distribuée autour d'une certaine valeur,
- des moyens de décollement, pour détacher une couche de matériau au niveau d'une profondeur de décollement située au voisinage de la profondeur d'implantation, et
- des moyens de rotation pour faire tourner le lingot, autour d'un axe parallèle à la surface cylindrique du lingot.

Ce dispositif permet la mise en oeuvre du procédé selon l'invention tel que décrit précédemment. Avantageusement il comporte des moyens de maintien de la couche de matériau située entre la surface cylindrique du lingot et la profondeur de décollement, pour recueillir ladite couche après son détachement du lingot. Avantageusement encore, ces moyens de maintien comportent une pluralité de moyens de préhension réversible répartis sur des moyens d'entraînement à rouleaux. Le principe de tels moyens de préhension est connu. De tels moyens de préhension agissent par exemple grâce à des différentiels de pression, des forces électrostatiques, etc.

D'autres aspects, buts et avantages de l'invention apparaîtront à la lecture de la description détaillée qui suit. L'invention sera également mieux comprise à l'aide des références aux dessins sur lesquels :
- la figure 1 représente schématiquement en perspective un lingot soumis à une implantation ionique et au détachement d'une couche de matériau, conformément à un premier exemple de mise en oeuvre du procédé de fabrication de substrats selon l'invention ;
- la figure 2 représente schématiquement en coupe transversale par rapport à l'axe du cylindre du lingot représenté à la figure 1, un exemple de dispositif de fabrication de substrats, conforme à la présente invention ;
- la figure 3 représente schématiquement en coupe transversale par rapport à l'axe du cylindre constitutif d'un lingot tel que celui représenté aux figures 1 et 2, un deuxième exemple de mise en oeuvre du procédé conforme à la présente invention ;
- la figure 4 représente schématiquement en coupe transversale par rapport à l'axe constitutif d'un lingot tel que celui représenté aux figures 1 à 3, un troisième exemple de mise en oeuvre du procédé conforme à la présente invention ;
- la figure 5 représente schématiquement en coupe transversale à l'axe du cylindre constitutif d'un lingot tel que celui représenté aux figures 1 à 4, une variante de l'exemple de mise en oeuvre du procédé conforme à la présente invention représenté à la figure 4;
- la figure 6 représente schématiquement en coupe transversale à l'axe du cylindre constitutif d'un lingot tel que celui représenté aux figures 1 à 5, une autre variante de l'exemple de mise en oeuvre du procédé conforme à la présente invention représenté à la figure 4 ;
- la figure 7 représente schématiquement en coupe transversale par rapport à l'axe constitutif d'un lingot tel que celui représenté aux figures 1 à 6, un quatrième exemple de mise en oeuvre du procédé conforme à la présente invention ;
- la figure 8 représente schématiquement en coupe transversale par rapport à l'axe constitutif d'un lingot tel que celui représenté aux figures 1 à 7, un cinquième exemple de mise en oeuvre du procédé conforme à la présente invention ;
- la figure 9 représente schématiquement en coupe transversale par rapport à l'axe constitutif d'un lingot tel que celui représenté aux figures 1 à 7, une variante du quatrième exemple de mise en oeuvre du procédé conforme à la présente invention ;
- la figure 10 représente schématiquement en coupe transversale par rapport à l'axe constitutif d'un lingot tel que celui représenté aux figures 1 à 9, un sixième exemple de mise en oeuvre du procédé conforme à la présente invention ;
- la figure 11a représente schématiquement en coupe perpendiculaire à la surface ayant subi le bombardement du procédé conforme à l'invention, un substrat obtenu grâce à un septième exemple de mise en oeuvre du procédé selon l'invention; la figure 11b représente schématiquement le profil de concentration des espèces atomiques implantées en fonction de la profondeur d'implantation, dans le substrat représenté à la figure 11a ;
- la figure 12a représente schématiquement en perspective trois couches destinées à être superposées selon un huitième exemple de mise en oeuvre du procédé selon l'invention ; la figure 12b représente la structure obtenue après l'assemblage des trois couches représentée sur la figure 12a ;
- la figure 13 représente schématiquement en coupe transversale à l'axe du cylindre constitutif du lingot représenté sur les figures 1 à 10, un neuvième exemple de mise en oeuvre du procédé conforme à la présente invention ; et
- la figure 14 représente schématiquement en coupe transversale par rapport à l'axe d'un lingot à section carrée, une variante de la présente invention.

Le procédé conforme à la présente invention va être présenté ci-dessous dans le cadre particulier de l'obtention de substrats de silicium monocristallin à partir d'un lingot obtenu par tirage CZ ou FZ. Le silicium a été choisi car il est, de loin le matériau le plus utilisé dans le domaine de la micro-électronique. Cependant, l'invention ne se limite pas à ce type de matériau. Dans sa généralité, l'invention s'applique à des lingots de matériaux quelconques monocristallins, polycristallins ou amorphes, et notamment semi-conducteurs.

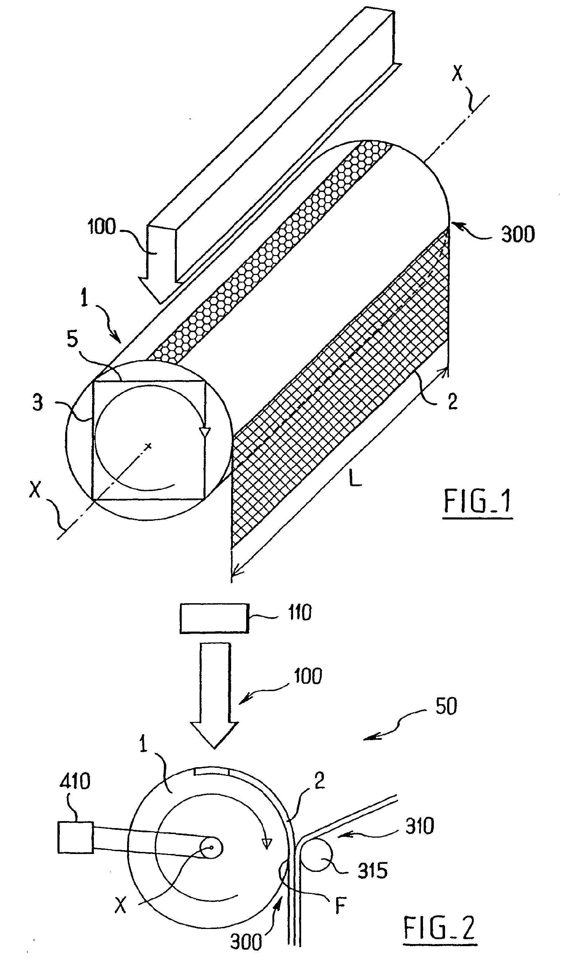

La figure 1 montre un lingot 1 de silicium monocristallin obtenu par tirage CZ ou FZ. Il a approximativement la forme d'un cylindre de révolution d'axe X-X. Ce lingot 1 a initialement un diamètre de 200 mm et une longueur L=1,5 m. Il est généralement coupé en tronçons. Le tirage a été choisi pour obtenir un lingot 1 orienté avec les faces perpendiculaires à l'axe du cylindre orientées parallèlement au plan cristallographique <1, 0, 0>. On a alors les plans <0, 0,
1 > 3 et <0, 1, 0> 5 parallèles à l'axe X-X du lingot 1.

Dix exemples de mise en oeuvre du procédé selon l'invention sont décrits ci-dessous.

### Exemple 1 :

Selon le premier exemple représenté sur la figure 1, le procédé conforme à l'invention comporte une opération d'implantation 100 d'espèces atomiques et une opération de détachement 300.

Dans cet exemple, les espèces atomiques, sont des ions H⁻. Ils sont implantés avec une haute énergie. Le faisceau de ces ions est allongé, dans la direction longitudinale du lingot. Pour obtenir une couche 2 de silicium d'une épaisseur de 10 µm, les ions H⁻ sont accélérés avec une énergie de 725 keV. Une dose d'ions H⁻ implantés de 1,21.10¹⁷/cm², est utilisée.

L'opération d'implantation 100 est réalisée en balayant la surface du lingot 1, avec un faisceau d'espèces atomiques accélérées, sur toute sa longueur, en adaptant la vitesse de rotation du lingot 1, à la largeur du faisceau et à la vitesse de balayage de manière à obtenir la dose appropriée.

Selon l'orientation cristallographique de la surface implantée, par rapport au faisceau incident des espèces atomiques, la profondeur d'implantation Rp varie. Avantageusement et en particulier pour les applications dans lesquelles les variations d'épaisseur de la couche 2 sont critiques, une modulation de l'épaisseur de la couche 2 obtenue, peut être évitée en modulant l'énergie d'implantation en fonction de l'angle de rotation. On notera cependant que si l'on utilise un lingot 1 de section carrée, ces problèmes de variations d'épaisseur peuvent être réduits voire annulés du fait que l'implantation peut être réalisée sur des faces dont l'orientation cristallographique est bien définie.

Par l'opération d'implantation 100 on crée, dans le volume du lingot 1 et à une profondeur voisine de la profondeur de pénétration des ions H⁻, une couche de fragilisation partageant le lingot 1 en une région inférieure constituant la masse du lingot 1 et une région supérieure constituant une couche 2 de matériau destinée à former le substrat souhaité.

La couche 2 dans le cas décrit ici fait environ 10 µm d'épaisseur. Cette épaisseur suffit à éviter la déformation de la couche (par exemple la formation de cloques) tandis que ces conditions d'implantations permettent une fragilisation suffisante au niveau de la profondeur de décollement, pour qu'un détachement de la couche 2 et du lingot 1 puisse être opéré à moindre effort.

La couche 2 séparée est avantageusement maintenue pour en permettre le déroulement.

La figure 2 représente un dispositif 50 de fabrication de substrats conforme à la présente invention, pour la mise en oeuvre du procédé illustré par la figure 1. Il comporte des moyens d'implantation 110 d'ions H⁻, des moyens de maintien 310 de la couche 2, une fois que celle-ci est séparée du lingot 1, et des moyens de rotation 410.

Les moyens d'implantation 110 sont constitués d'un implanteur. Cet implanteur produit des ions H- accélérés sous une énergie de l'ordre du MeV. Ce type d'implanteur a été initialement développé par le JAERI ("Japan Atomic Energy Research Institute").

Les moyens de rotation 410 font tourner le lingot 1 autour de l'axe X-X.

Les moyens de maintien 310 sont constitués d'un support 6. Le support 6 est avantageusement un film adhésif. La couche 2 est directement mise au contact du support 6. Le support 6 est pressé contre la couche 2 grâce à un rouleau d'application 320. Ce rouleau d'application 320 est monté sur un axe mobile de manière à ce qu'il puisse suivre le déplacement de la surface du lingot 1, au cours de la réduction de son diamètre consécutive de l'enlèvement de matière. Ainsi, lorsque le lingot 1 commence à tourner autour de l'axe X-X sans avoir été implanté, aucun transfert de la couche 2 ne s'effectue sur le support 6. Puis, lorsque l'opération d'implantation 100 est démarrée, et que la zone implantée parvient au contact du support 6, ce dernier permet le transfert de la couche 2 sur le support 6. Après contact avec la couche 2, il écarte cette dernière du reste du lingot 1. Le transfert de la couche 2 sur le support 6 peut ensuite se poursuivre.

### Exemple 2 :

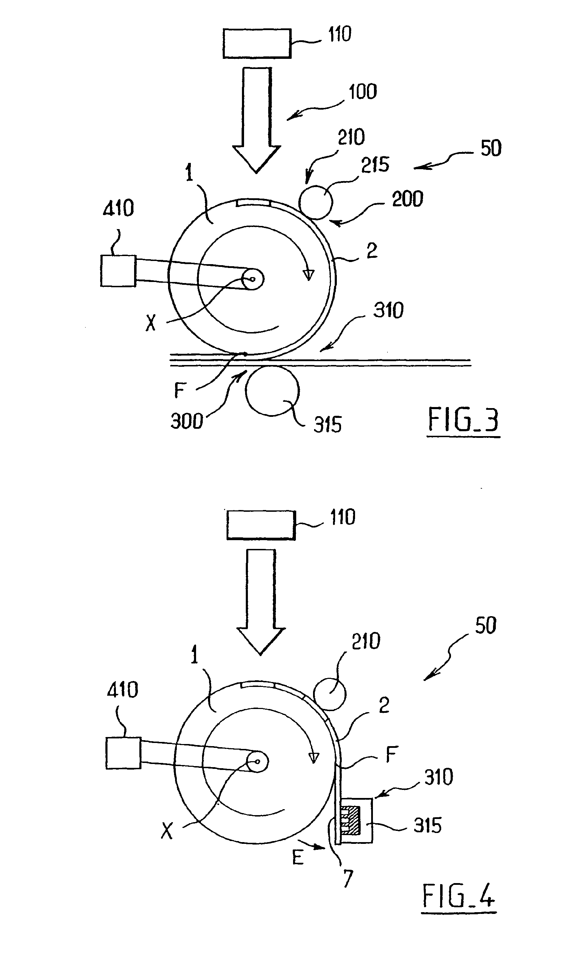

Selon le deuxième exemple de mise en oeuvre du procédé selon l'invention, représenté sur la figure 3, celui-ci comporte une opération d'implantation 100, une opération de chauffage 200 et une opération de détachement 300.

Les espèces implantées sont avantageusement des ions hydrogène. Ces ions sont implantés avec une énergie de l'ordre de 700 keV et une dose de l'ordre de 10¹⁷ cm⁻².

Le lingot 1 tournant de manière continue autour de son axe X-X, la zone de la surface du lingot 1, bombardée par les espèces atomiques au cours de l'opération d'implantation 100, se déplace vers une zone de chauffage.

L'opération de chauffage 200 est réalisée après l'opération d'implantation 100 par des moyens de chauffage 210. L'opération de chauffage 200 aide au détachement de la couche 2 située entre la surface et la profondeur de décollement, du reste du lingot 1. L'opération de chauffage 200 permet de réduire les doses d'espèces atomiques implantées, par rapport à la dose mentionnée dans l'exemple 1.

Les moyens de chauffage 210 sont constitués d'un rouleau chauffant 215, cylindrique de révolution autour d'un axe parallèle à l'axe de rotation du lingot 1. Le rouleau chauffant 215 est placé en aval des moyens d'implantation 110, relativement au mouvement de rotation du lingot 1. Le rouleau chauffant 215 est au contact du lingot 1. Avantageusement ces moyens de chauffage 210 permettent de porter la surface du lingot 1, localement à une température voisine de 500°C/600° C. Cette température est en fait à ajuster en fonction du temps d'application des moyens de chauffage 210 et des conditions d'implantation, telles que la dose et l'énergie d'implantation. Ces derniers paramètres dose et énergie déterminent également la température atteinte par la surface du lingot 1 pendant l'opération d'implantation 100. Ce chauffage du lingot 1 par l'implantation est à prendre en compte dans le budget thermique déterminant les conditions de détachement de la couche 2 du reste du lingot 1. Le temps d'application des moyens de chauffage 210 dépend également de la surface d'application, de la vitesse de rotation du lingot 1, etc.

La couche 2 est ensuite transférée sur un support 6, comme décrit dans l'exemple 1.

### Exemple 3 :

Selon le troisième exemple de mise en oeuvre du procédé selon l'invention, représenté sur la figure 4, celui-ci comporte une opération d'implantation 100 et une opération de chauffage 200, telles que celles de l'exemple 2, auxquelles est ajoutée une opération de détachement 300 réalisée à l'aide de moyens de maintien 310. Ces moyens de maintien 300 peuvent agir grâce à un différentiel de pression, à une force électrostatique, à une force d'adhésion réversible (par application d'un adhésif de faible adhésivité), etc.

Lorsque ces moyens de maintien 310 sont à dépression, ils sont avantageusement constitués d'une barre 315 dont la longueur s'étend parallèlement à l'axe X-X du lingot 1. Cette barre 315 est creuse. Une dépression est réalisée dans cette barre, qui permet de maintenir, de manière réversible, la couche 2 par aspiration. Le détachement de la couche 2 du reste du lingot 1 est favorisée par l'opération de chauffage 200.

Pour commencer à peler la couche 2 du lingot 1, on applique sur la première zone du lingot 1 ayant subi les opérations d'implantation 100 et de chauffage 200, les moyens de maintien 310. Du fait de l'aspiration dans la barre 315, il se produit sur la couche 2 des contraintes mécaniques. Ces contraintes mécaniques sont renforcées par un mouvement d'écartement E de la barre 315 par rapport au lingot 1. On obtient alors un front d'écartement F.

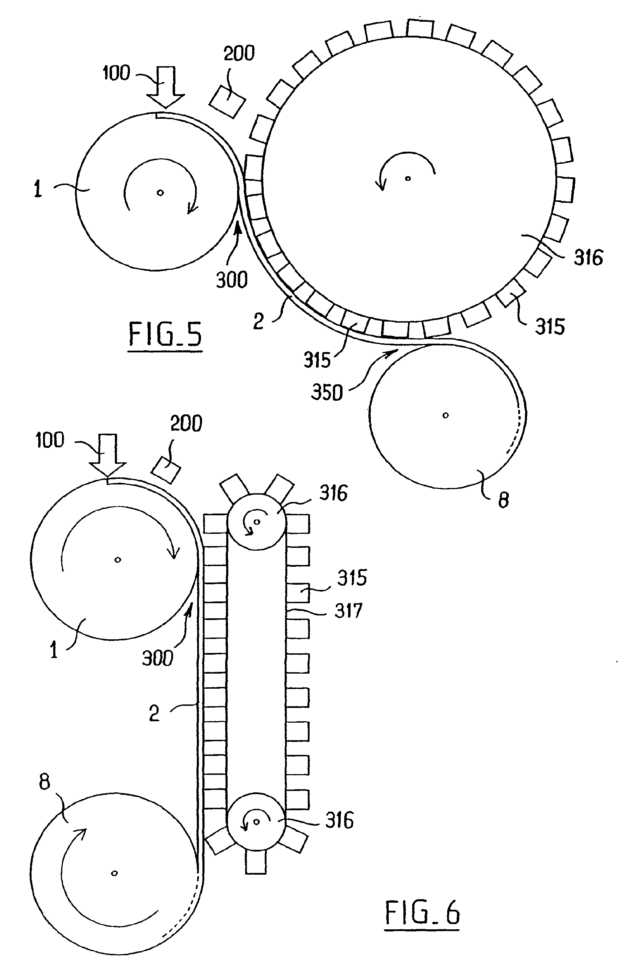

Le déplacement des moyens de maintien 310 est par exemple réalisé selon les modes de mise en oeuvre représentés sur les figures 5 et 6.

Selon le mode de mise en oeuvre illustré par la figure 5, des barres 315 sont réparties sur la périphérie d'un rouleau d'entraînement 316. Le mode de mise en oeuvre illustré par la figure 6 correspond dans son principe à celui illustré par la figue 5, à la différence que les barres 315 sont réparties sur un tapis roulant 317, se déplaçant de manière rectiligne entre deux rouleaux d'entraînement 316.

Selon les modes de mise en oeuvre illustrés par les figures 5 et 6, une dépression est créée dans la barre 315, juste avant qu'elle n'entre en contact du lingot 1. Au moment du contact la barre 315 adhère à la surface du lingot 1. Si le lingot n'a pas subit les opérations d'implantation 100 et de chauffage 200, au niveau de la zone de contact entre le lingot 1 et la barre 315, ces derniers se déplacent l'un par rapport à l'autre et le contact est rompu. Si par contre, le lingot a subit une opération d'implantation 100 au niveau de la zone de contact entre le lingot 1 et la barre 315, la couche 2 se sépare du reste du lingot 1 et est maintenue par la barre 315. Le vide est alors cassé dans la barre 315 lorsque la zone de la couche 2 maintenue par la barre 315 parvient au niveau d'un rouleau de stockage 8.

Ce mode de mise en oeuvre présente l'avantage par rapport au précédent, que la couche 2 est moins soumise à des contraintes mécaniques du fait qu'il n'y a pas d'inversion de courbure de la couche 1 entre l'opération de détachement 300 et celle de stockage sur le rouleau de stockage 8.

Selon une variante de ces modes de mise en oeuvre du procédé selon l'invention, la couche 2 est reportée sur un support 6. Dans ce cas, la couche 2 est écartée du lingot 1 grâce aux moyens de maintien 310, comme indiqué précédemment, puis reportée sur un support 6, auquel elle adhère. La couche 2 est alors relâchée par les moyens de maintien 310, et entraînée par le support 6.

Selon cette variante, la couche 2 est éventuellement découpée en feuilles avant ou après report sur le support 6.

### Exemple 4 :

Selon le quatrième exemple de mise en oeuvre du procédé selon l'invention, celui-ci comporte une opération d'implantation 100, une opération de transfert 400 sur un support 6 raidisseur et une opération de chauffage 200, avant ou pendant l'opération de transfert 400.

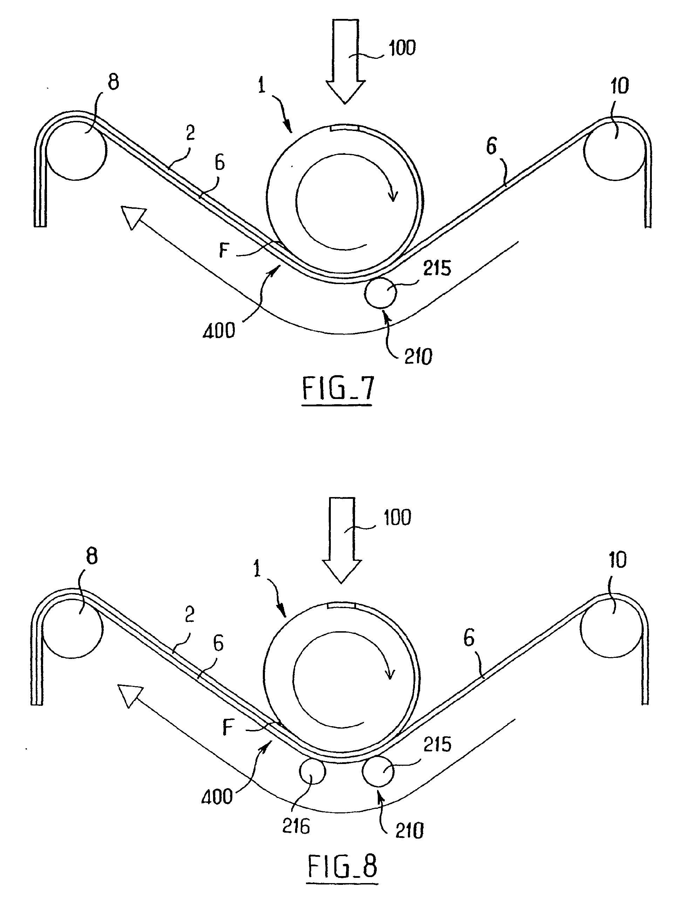

Ce mode de mise en oeuvre est illustré par la figure 7.

Selon ce mode de mise en oeuvre, l'opération d'implantation 100 est réalisée avec une énergie de 100 à 200 KeV. Ce type d'énergie est insuffisant pour réaliser des couches 2 autoportées. Le support 6 joue alors un rôle de raidisseur. Ce dernier permet d'éviter les cassures de la couche 2 et/ou ses déformations (la formation de cloques par exemple).

Le support 6 est avantageusement un film adhésif. Ce film adhésif est par exemple constitué d'une résine polymère (ou d'un autre composé adapté à cette fonction) qui devient adhésive lorsqu'on la chauffe ou qu'on l'irradie avec un rayonnement UV. Ce film adhésif est tendu entre deux rouleaux 8, 10 entre lesquels le lingot 1 est pressé sur le support 6. L'axe de ces rouleaux 8, 10 et du lingot 1 sont parallèles entre eux. Le support 6 est initialement enroulé sur un rouleau d'approvisionnement 10.

Le lingot 1 est mis en rotation sur son axe X-X grâce aux moyens de rotation 410.

Les moyens de chauffage 210 sont, dans cet exemple, sous forme d'un rouleau 215. Celui-ci presse l'un contre l'autre, le support 6 et la couche 2, en même temps qu'il les chauffe. Le support 6 sert de raidisseur qui évite la déformation de la couche 2 (cloques par exemple) susceptible d'intervenir pendant l'opération de chauffage 200 quasi-simultanée à la mise en contact de la couche 2 et du support 6. L'opération de chauffage 210 permet de renforcer l'adhésion entre le support 6 et la couche 2 et de contribuer à la fragilisation du lingot 1 au niveau de la profondeur de décollement.

Après adhésion au support 6, la couche 2 quitte le lingot 1 au niveau du front d'écartement F. La synchronisation de la rotation du lingot 1, avec le déplacement du support 6, permet de propager l'écartement de la couche 2 par rapport au lingot 1, au niveau du front F. Au niveau du front d'écartement F, l'état de fragilisation est suffisant pour que les contraintes mécaniques appliquées au lingot 1 par le support 6 achèvent le détachement.

Si les paramètres d'implantation et de chauffage ont été choisis pour qu'il en soit ainsi, le détachement de la couche 2 et du lingot 1 a déjà été réalisée au niveau de l'opération de chauffage 200, et le support 6 ne fait qu'entraîner la couche 2, en l'écartant du lingot 1.

L'ensemble couche 2/support 6 est ensuite enroulé pour être stocké sur un rouleau de stockage 8.

En variantes, le support 6 peut avoir été préchauffé avant d'être mis en contact avec le lingot 1 ou encore le lingot 1 peut avoir été préchauffé avant que le support 6 ne soit mis en contact avec lui.

Selon une autre variante du mode de mise en oeuvre du procédé selon l'invention, décrit ci-dessus, un coin, une lame, ou un autre type de contact mécanique, ou bien encore un jet de fluide, tel que du gaz, est utilisé pour initier l'écartement de la couche 2 par rapport au lingot 1.

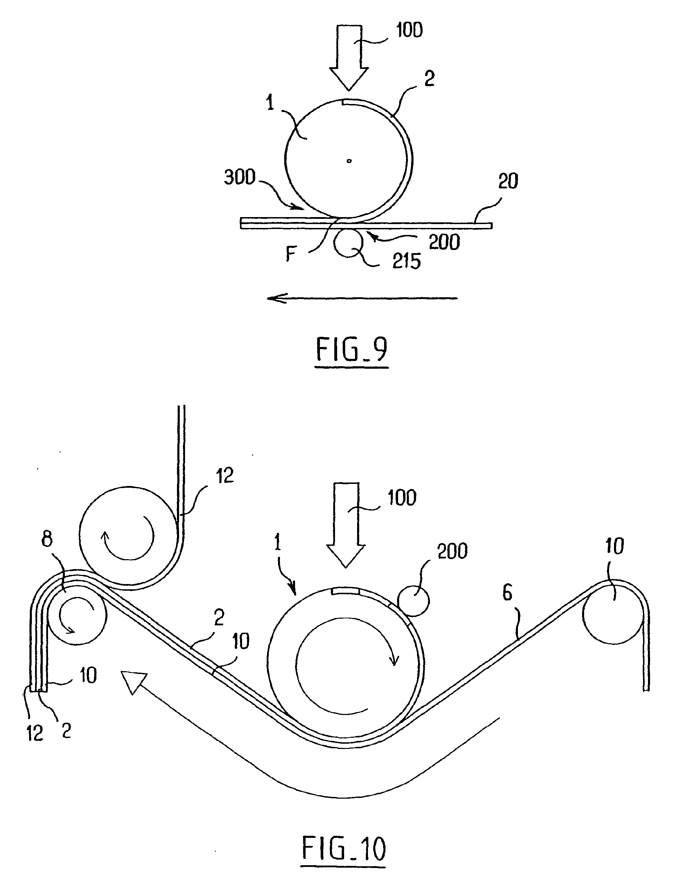

Selon encore une autre variante de ce mode de mise en oeuvre, le support 6 est sous forme d'une plaque 20 (voir figure 9). La plaque 20 est rigide. Elle est en verre ou en quartz, par exemple. Ainsi, on peut réaliser une opération 100 d'implantation puis transférer la couche 2 sur une plaque 20 éventuellement chauffée pour faciliter le détachement et le transfert de la couche 2 sur cette plaque 20, ainsi que l'adhésion de ces dernières l'une sur l'autre. Il est aussi possible d'interrompre l'opération d'implantation 100 pour achever le transfert d'une partie de la couche 2 déjà implantée, sur la plaque 20, puis recommencer avec une nouvelle plaque 20.

### Exemple 5 :

Le cinquième exemple de mode de mise en oeuvre du procédé selon l'invention dérive du quatrième exemple de mise en oeuvre, illustré par la figure 7. Ce cinquième mode de mise en oeuvre, illustré par la figure 8, comporte une opération d'implantation 100, une opération de chauffage 200 et une opération de transfert 400 sur un support 6 raidisseur, comme dans le quatrième exemple, mais il comporte en outre une opération consistant à créer un choc thermique. Après l'opération d'implantation 100, le lingot 1 se trouve à une température relativement élevée. En pressant un rouleau 216 refroidissant contre le lingot 1, sur les zones ayant subi l'opération d'implantation, on produit un choc thermique qui facilite le détachement de la couche 2 et du lingot 1.

### Exemple 6 :

Selon le sixième exemple de mise en oeuvre du procédé selon l'invention, celui-ci comporte une opération d'implantation 100, une opération de chauffage 200 et une opération de détachement 300, toutes du même type que celles de l'exemple 4. Mais en outre il comporte une opération consistant à recouvrir la couche 2 déposée sur le support 6 par un matériau de recouvrement 12. Ce matériau de recouvrement 12 est déposé sous forme d'un film, ou en phase liquide ou encore en phase gazeuse. Ce mode de mise en oeuvre est illustré par la figure 10. On obtient alors un système de trois couches 6, 2 et 16. Un exemple d'utilisation d'un tel mode de mise en oeuvre est décrit ci-dessous à l'exemple 8.

### Exemple 7 :

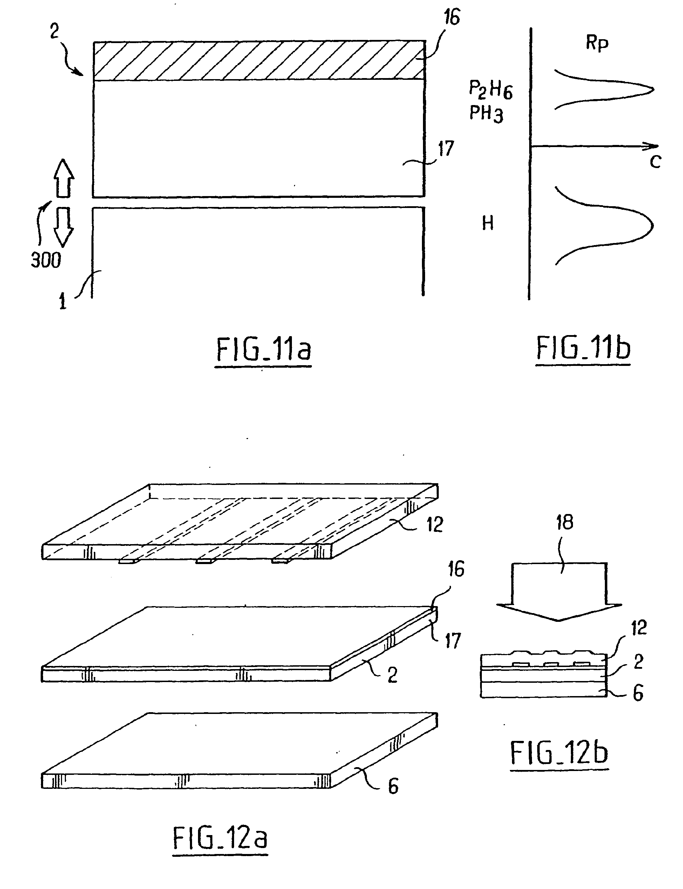

Selon le septième exemple de mise en oeuvre du procédé selon l'invention, celui-ci comporte une opération d'implantation 100, qui selon cet exemple, s'effectue avantageusement simultanément avec des ions H- et des ions phosphore (figure 11 a). Avec une même énergie d'accélération, les ions H⁻sont implantés plus profondément que les ions phosphore, car ils sont moins lourds. Les ions H⁻ déterminent donc la profondeur à laquelle aura lieu le détachement, tandis que, les ions phosphore produisent une couche de dopage 16, dopée n. La couche sous-jacente à la couche de dopage 16 forme une couche dopée p 17. La figure 11b représente le profil de la concentration C des espèces atomiques H- ainsi que P₂H₆ et PH₃ en fonction de la profondeur d'implantation dans la couche 2 et le lingot 1, représentés sur la figure 11a. On peut donc ainsi réaliser en même temps un dopage et une implantation destinée à un détachement.

Des opérations de chauffage 200, de détachement 300 et de transfert 400 telles que celles décrits dans l'exemple 4 complètent avantageusement ce mode de mise en oeuvre.

### Exemple 8 :

Le huitième exemple de mode de mise en oeuvre du procédé selon l'invention, dérive des sixième et septième exemples de mise en oeuvre décrits ci-dessus. Selon ce huitième exemple, illustré par les figures 12a et 12b, le support 6 et le matériau de recouvrement 12 comportent déjà des motifs.

La figure 12a représente un support 6, une couche 2 et un matériau de recouvrement 12. Le support 6 comporte des motifs d'interconnexion (non représentés). La couche 2 de silicium est obtenue à partir d'un lingot 1 de silicium grâce au procédé selon l'invention. Cette couche 2 comporte une couche de dopage 16 dopée n avantageusement dopée au phosphore ou à l'arsenic ainsi qu'une couche dopée p 17, comme indiqué ci-dessus dans l'exemple 7. Le matériau de recouvrement 12 comporte également des motifs d'interconnexion. L'ensemble de ces trois couches 6, 2 et 12 est assemblé selon le procédé conforme à la présente invention, par exemple selon la variante illustrée par la figure 6. On obtient alors un dispositif photovoltaïque tel que celui représenté sur la figure 12b, pour lequel l'exposition aux photons 18 est réalisée sur la face comportant le matériau de recouvrement 12.
Le matériau de recouvrement 12 servira de revêtement antireflet. La surface de la couche 2 est rugueuse car elle n'a pas été polie après l'opération de détachement 300 du procédé conforme à la présente invention. Ainsi, cela permet une pénétration de la lumière 18 dans cette couche 2 avec des réflexions multiples.

### Exemple 9 :

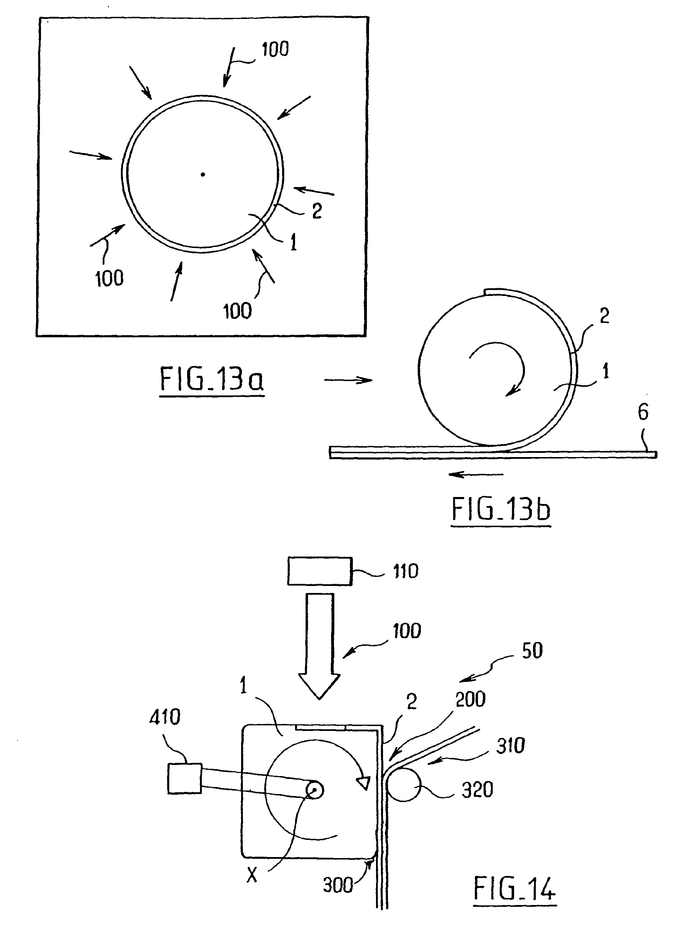

Selon le neuvième exemple de mise en oeuvre du procédé selon l'invention, représenté sur les figures 13a et 13b, l'opération d'implantation 100 est réalisée sur la totalité de la surface du lingot 1. Pour ce faire, le lingot 1 est placé dans une chambre d'implantation à plasma où les espèces atomiques sont accélérées sous la tension voulue (figure 13a).

Le lingot 1 subit alors ou non une opération de chauffage 200 (cela dépend des conditions utilisées dans l'opération d'implantation 100 précédente).

Le lingot 1 est ensuite sorti de la chambre d'implantation pour peler la couche 2. La couche 2 est avantageusement transférée sur un support 6, selon l'un des exemples précédents (figure 13b).

Selon une variante de cet exemple, le lingot 1 subit les autres opérations aboutissant à la formation de la couche 2 dans la même chambre que celle où a été effectuée l'opération d'implantation 100.

### Exemple 10:

Selon le dixième exemple de mise en oeuvre du procédé selon l'invention, représenté sur la figure 14, celui-ci comporte une opération d'implantation 100, une opération de chauffage 200 et une opération de détachement 300, conformes à celles décrites en relation avec l'exemple 2, mais le lingot 1 présente une section transversale à son axe longitudinal, carrée. L'opération de chauffage 200 et de détachement 300 sont menées simultanément grâce à un rouleau chauffant 215. Ce rouleau chauffant 215 est monté sur un axe mobile de manière à ce qu'il puisse suivre le déplacement des faces du lingot 1, au cours de sa rotation, ainsi que pour suivre le déplacement de la surface du lingot 1, au cours de la réduction de son diamètre consécutive de l'enlèvement de matière.

De nombreuses variantes du procédé selon l'invention sont obtenues en combinant les différents exemples de mise en oeuvre exposés ci-dessus.
Dans les exemples de mise en oeuvre décrits ci-dessus, l'opération d'implantation 100 est réalisée en bombardant la surface du lingot 1, soit avec un faisceau d'espèces atomiques, soit par immersion dans un plasma. Lorsque l'on utilise un faisceau d'espèces atomiques, celui ci peut avoir une forme linéaire, rectangulaire ou toute autre géométrie. On peut également utiliser plusieurs faisceaux bombardant le lingot 1, radialement, simultanément en plusieurs points de sa surface voire de manière à couvrir la totalité de cette surface.

Dans les exemples de mise en oeuvre décrits ci-dessus, une opération de chauffage 200 pouvait être réalisée pour favoriser et/ou provoquer le détachement de la couche 2 et du lingot 1. Cette opération était éventuellement complétée par une application de contraintes mécaniques pour achever ledit détachement et écarter la couche 2 du reste du lingot 1. Mais le détachement de la couche 2 et du lingot 1 peut être favorisée et/ou provoquée uniquement par l'opération de chauffage 200. Elle peut également être favorisée et/ou provoquée uniquement par des contraintes mécaniques.

De même, dans les exemples de mises en oeuvre décrits ci-dessus, l'espèce atomique implantée pour créer des microcavités est l'hydrogène. D'autres espèces atomiques peuvent être également utilisées. On citera à titre d'exemple l'hélium, le bore, etc. Le bore est avantageusement utilisé pour doper la couche en même temps que favoriser ou créer le détachement. Le bore peut également avantageusement permettre de réduire les doses des espèces atomiques implantées et/ou les températures et/ou temps de chauffage de l'éventuelle opération de chauffage 200 (voir par exemple le brevet US 5 877 070).

Pour certaines applications, et notamment lorsque l'on souhaite protéger la surface du lingot 1 exposé à l'implantation, une couche tampon déposée en amont de l'opération d'implantation 100, relativement au mouvement de rotation du lingot 1, peut être ajoutée.

De même, il peut être intéressant de déposer un raidisseur sur le lingot 1, avant même l'opération d'implantation 100.
D'une manière générale, selon les applications recherchées, il peut être utile de déposer un support 6 (raidisseur, couche réfléchissante, etc.) avant ou après que la couche 2 ait été pelée, et ceci sur une de ses faces ou sur les deux.

Selon encore une variante du procédé selon l'invention, la couche 2 est transférée temporairement sur un support 6 jouant le rôle de raidisseur permettant de procéder à une opération de détachement 300, ou même seulement une opération de pré-détachement telle qu'une opération de chauffage 200, en évitant les déformations telles que celles provenant de la formation de cloques. Ce support 6 sert avantageusement au transport de la couche 2, du lingot 1 dont elle est issue sur des moyens de stockage, ou avant que cette couche 2 ne soit transférée sur un autre support qui lui conférera la tenue mécanique souhaitée. On peut ainsi faire adhérer temporairement la couche 2 sur le support 6 temporaire, jouant éventuellement également un rôle de raidisseur, sur une face, puis faire adhérer un autre support sur l'autre face, et enfin, retirer le support 6 temporaire.

Un rouleau en contact avec le lingot 1, en aval des moyens d'implantation 110, peut également jouer le rôle de raidisseur temporaire. Cette variante est avantageusement combinée avec un opération de chauffage 200.

## Revendications

1. Procédé de fabrication de substrats, notamment pour l'optique, l'électronique ou l'optoélectronique, comprenant
- une opération consistant à implanter (100) des espèces atomiques sous la surface d'un matériau (1), à une profondeur d'implantation distribuée autour d'une certaine valeur en bombardant ces espèces atomiques sur une zone de la surface du matériau, et
- une opération de détachement (300), au niveau d'une profondeur de décollement située au voisinage de la profondeur d'implantation, de la couche (2) de matériau située entre la surface et la profondeur de décollement, pour détacher cette couche (2) du reste du matériau (1). le procédé étant **caractérisé en ce que**
- le matériau est sous la forme d'un lingot (1) cylindrique, et
- l'opération d'implantation (100) est réalisée en faisant tourner le lingot autour d'un axe parallèle à sa surface cylindrique.

2. Procédé selon la revendication 1, **caractérisé par le fait que** l'implantation (100) des espèces atomiques est réalisée en bombardant en continu la surface cylindrique du lingot (1), avec un balayage, dans la direction longitudinale du lingot, avec un faisceau ponctuel, tandis que l'on fait tourner ce dernier autour d'un axe parallèle à cette surface cylindrique.

3. Procédé selon la revendication 1, **caractérisé par le fait que** l'implantation (100) des espèces atomiques est réalisée en bombardant en continu la surface cylindrique du lingot (1), avec un faisceau de section allongée correspondant à une aire donnée, tandis que l'on fait tourner ce dernier autour d'un axe parallèle à cette surface cylindrique.

4. Procédé selon la revendication 1, **caractérisé par le fait que** l'implantation (100) des espèces atomiques est réalisée par des bombardements successifs correspondant à une aire donnée, de zones adjacentes de la surface cylindrique du lingot (1), en faisant tourner le lingot (1) autour d'un axe parallèle à cette surface cylindrique du lingot (1), entre chaque bombardements.

5. Procédé selon l'une des revendications précédentes **caractérisé par le fait que** l'on bombarde la totalité de la surface cylindrique du lingot (1).

6. Procédé selon la revendication 5, **caractérisé par le fait que** l'on bombarde en continu la totalité de la surface cylindrique du lingot (1) en immergeant le lingot (1) dans un plasma

7. Procédé selon l'une des revendications précédentes, **caractérisé par le fait qu'**il comprend en outre, une opération de chauffage (200).

8. Procédé selonl'une des revendications précédentes, **caractérisé par le fait qu'**il comporte une opération consistant à transférer la couche (2) de matériau située entre la surface cylindrique du lingot (1) et la profondeur de décollement, sur un support (6).

9. Procédé selon la revendication 8, **caractérisé par le fait qu'**il comporte une opération consistant à presser la couche (2) de matériau située entre la surface cylindrique du lingot (1) et ta profondeur de décollement, sur le support (6), grâce à un rouleau refroidissant (216).

10. Procédé selon l'une des revendications 8 et 9, **caractérisé par le fait que** le support (6) est adhésif.

11. Procédé selon l'une des revendications précédentes, **caractérisé par le fait qu'**il comporte une opération consistant à recouvrir la couche (2) de matériau située entre la surface cylindrique du lingot (1) et la profondeur de décollement, par un dépôt en phase liquide ou un dépôt en phase gazeuse.

12. Procédé selonl'une des revendications précédentes, **caractérisé par le fait que** ledit matériau est du silicium.

13. Procédé selon l'une des revendications précédentes, **caractérisé par le fait que** les espèces atomiques comprennent des ions hydrogène.

14. Procédé selon la revendication 13, **caractérisé par le fait que** les espèces atomiques comprennent des ions de dopage tels que du phosphore ou de l'arsenic.

15. Procédé selon l'une des revendications précédentes, **caractérisé par le fait qu'**il comporte des opérations consistant à reporter par laminage entre des rouleaux, une couche (6,12) sur chacune des faces de la couche (2) de matériau située entre la surface cylindrique du lingot (1) et la profondeur de décollement.

16. Procédé selon l'une des revendications précédentes, **caractérisé par le fait qu'**il comporte une opération consistant à reporter au moins une couche (6,12) comprenant des motifs de circuiterie, sur la couche (2) de matériau située entre la surface cylindrique du lingot (1) et la profondeur de décollement.

17. Procédé selon l'une des revendications précédentes, **caractérisé par le fait que** le lingot (1) a une section circulaire.

18. Procédé selon l'une des revendications précédentes, **caractérisé par le fait que** le lingot (1) a une section carrée.

19. Dispositif de fabrication de substrats, notamment pour l'optique, l'électronique ou l'optoélectronique, comprenant
- des moyens d'implantation (110) d'espèces atomiques sous la surface d'un matériau, à une profondeur d'implantation distribuée autour d'une certaine valeur,
- des moyens de décollement (210, 310), pour détacher une couche (2) de matériau au niveau d'une profondeur de décollement située au voisinage de la profondeur d'implantation, et
**caractérisé en ce qu'**il comprend en outre des moyens de rotation (410) pour faire tourner un lingot (1) cylindrique du matériau, autour d'un axe parallèle à la surface cylindrique du lingot (1).

20. Dispositif selon la revendication 19, **caractérisé par le fait qu'**it comporte des moyens de maintien (310) de la couche (2) de matériau située entre la surface cylindrique du lingot (1) et la profondeur de décollement, pour recueillir ladite couche (2) après sa détachement du lingot (1).

21. Dispositif selon la revendications 20, **caractérisé par le fait que** les moyens de maintien (310) comportent une pluralité de moyens de préhension (315) à dépression répartis sur des moyens d'entrainement à rouleaux (316, 317).

## Claims

1. Method of fabricating substrates, in particular for optics, electronics or optoelectronics, comprising:
- implanting (100) atomic species under the surface of a material (1) at an implantation depth distributed around a particular value by bombarding said atomic species onto an area of the surface of the material, and
- detaching (300), at a separation depth in the vicinity of the implantation depth, the material layer (2) between the surface and the separation depth, in order to detach this layer (2) from the remainder of the material (1), the method being **characterized in that**
- the material is in the form of a cylindrical ingot (1), and
- implanting (100) is carried out by rotating the ingot about an axis parallel to its cylindrical surface.

2. Method according to Claim 1, **characterized in that** implanting (100) the atomic species is carried out by continuously bombarding the cylindrical surface of the ingot (1) with a localized beam swept in the longitudinal direction of the ingot while the ingot is rotated about an axis parallel to the cylindrical surface.

3. Method according to Claim 1, **characterized in that** implanting (100) the atomic species is carried out by continuously bombarding the cylindrical surface of the ingot (1) with a beam of elongate cross section corresponding to a given area while the ingot is rotated about an axis parallel to the cylindrical surface.

4. Method according to Claim 1, **characterized in that** implanting (100) the atomic species is carried out by successive bombardment corresponding to a given area of adjacent zones of the cylindrical surface of the ingot (1) while the ingot (1) is rotated about an axis parallel to the cylindrical surface of the ingot (1) between each bombardment.

5. Method according to any preceding claim, **characterized in that** the whole of the cylindrical surface of the ingot (1) is bombarded.

6. Method according to Claim 5, **characterized in that** the whole of the cylindrical surface of the ingot
(1) is continuously bombarded by immersing the ingot
(1) into a plasma.

7. Method according to any preceding claim, **characterized in that** it further comprises heating (200).

8. Method according to any preceding claim, **characterized in that** it comprises transferring the material layer (2) between the cylindrical surface of the ingot (1) and the separation depth onto a support (6).

9. Method according to Claim 8, **characterized in that** it comprises pressing the material layer (2) between the cylindrical surface of the ingot (1) and the separation depth onto the support (6) by means of a cooling roller (216).

10. Method according to Claim 8 or 9, **characterized in that** the support (6) is adhesive.

11. Method according to any preceding claim, **characterized in that** it comprises covering the material layer (2) between the cylindrical surface of the ingot (1) and the separation depth by chemical liquid deposition or chemical vapour deposition.

12. Method according to any preceding claim, **characterized in that** said material is silicon.

13. Method according to any preceding claim, **characterized in that** the atomic species comprise hydrogen ions.

14. Method according to Claim 13, **characterized in that** the atomic species comprise doping ions such as phosphorus or arsenic ions.

15. Method according to any preceding claim, **characterized in that** it comprises applying a layer (6, 12) to each face of the material layer (2) between the cylindrical surface of the ingot (1) and the separation depth by rolling those layers between rollers.

16. Method according to any preceding claim, **characterized in that** it comprises transferring at least one layer (6, 12) comprising circuitry patterns onto the material layer (2) between the cylindrical surface of the ingot (1) and the separation depth.

17. Method according to any preceding claim, **characterized in that** the ingot (1) has a circular cross section.

18. Method according to any preceding claim, **characterized in that** the ingot (1) has a square cross section.

19. Device for fabricating substrates, in particular for use in optics, electronics or optoelectronics, comprising:
- means for implantation (110) of atomic species under the surface of a material (1) at an implantation depth distributed around a particular value,
- detaching means (210, 310) for detaching a material layer (2) at a separation depth in the vicinity of the implantation depth, and
**characterized in that** it further comprises rotation means (410) for rotating a cylindrical ingot (1) of the material about an axis parallel to the cylindrical surface of the ingot (1).

20. Device according to Claim 19, **characterized in that** it comprises holding means (310) for holding the material layer (2) between the cylindrical surface of the ingot (1) and the separation depth to gather up said layer (2) after it is detached from the ingot (1).

21. Device according to Claim 20, **characterized in that** the holding means (310) comprise a plurality of suction gripping means (315) distributed over drive roller means (316, 317).

## Patentansprüche

1. Verfahren zur Herstellung von Substraten, insbesondere für die Optik, die Elektronik oder die Optoelektronik, das
- eine Implantierung (100) von Atomarten unter die Oberfläche eines Werkstoffs (1) in eine um einen bestimmten Wert herum verteilte Implantierungstiefe, wobei diese Atomarten auf eine Zone der Oberfläche des Werkstoffs bombardiert werden, und
- eine Ablösung (300), in Höhe einer sich in der Nähe der Implantierungstiefe befindenden Ablösungstiefe der sich zwischen der Oberfläche und der Ablösungstiefe befindenden Werkstoffschicht (2), um diese Schicht (2) vom Rest des Werkstoffs (1) abzulösen, aufweist
wobei das Verfahren **dadurch gekennzeichnet ist, dass**
- der Werkstoff in Form eines zylindrischen Barrens (1) vorliegt, und
- die Implantierung (100) durch Drehung des Barrens um eine Achse parallel zu seiner zylindrischen Oberfläche durchgeführt wird.

2. Verfahren nach Anspruch 1, **dadurch gekennzeichnet, dass** die Implantierung (100) der Atomarten durch eine kontinuierliche Bombardierung der zylindrischen Oberfläche des Barrens (1) mit einem Überstreichen in Längsrichtung des Barrens mit einem punktförmigen Strahl durchgeführt wird, während letzterer um eine Achse parallel zu dieser zylindrischen Oberfläche gedreht wird.

3. Verfahren nach Anspruch 1, **dadurch gekennzeichnet, dass** die Implantierung (100) der Atomarten durch eine kontinuierliche Bombardierung der zylindrischen Oberfläche des Barrens (1) mit einem Strahl mit einem gegebenen Bereich entsprechenden länglichen Querschnitt durchgeführt wird, während letzterer um eine Achse parallel zu dieser zylindrischen Oberfläche gedreht wird.

4. Verfahren nach Anspruch 1, **dadurch gekennzeichnet, dass** die Implantierung (100) der Atomarten durch einem gegebenen Bereich entsprechende aufeinanderfolgende Bombardierungen von benachbarten Zonen der zylindrischen Oberfläche des Barrens (1) durchgeführt wird, indem der Barren (1) zwischen jeder Bombardierung um eine Achse parallel zu dieser zylindrischen Oberfläche des Barrens (1) gedreht wird.

5. Verfahren nach einem der vorhergehenden Ansprüche,
**dadurch gekennzeichnet, dass** die Gesamtheit der zylindrischen Oberfläche des Barrens (1) bombardiert wird.

6. Verfahren nach Anspruch 5, **dadurch gekennzeichnet, dass** die Gesamtheit der zylindrischen Oberfläche des Barrens (1) kontinuierlich bombardiert wird, indem der Barren (1) in ein Plasma eingetaucht wird.

7. Verfahren nach einem der vorhergehenden Ansprüche,
**dadurch gekennzeichnet, dass** es weiter einen Heizvorgang (200) enthält.

8. Verfahren nach einem der vorhergehenden Ansprüche,
**dadurch gekennzeichnet, dass** es einen Vorgang aufweist, der darin besteht, die sich zwischen der zylindrischen Oberfläche des Barrens (1) und der Ablösungstiefe befindende Werkstoffschicht (2) auf einen Träger (6) zu übertragen.

9. Verfahren nach Anspruch 8, **dadurch gekennzeichnet, dass** es einen Vorgang aufweist, der darin besteht, die sich zwischen der zylindrischen Oberfläche des Barrens (1) und der Ablösungstiefe befindende Werkstoffschicht (2) mit Hilfe einer Kühlwalze (216) auf den Träger (6) zu pressen.

10. Verfahren nach einem der Ansprüche 8 und 9,
**dadurch gekennzeichnet, dass** der Träger (6) klebefähig ist.

11. Verfahren nach einem der vorhergehenden Ansprüche, **dadurch gekennzeichnet, dass** es einen Vorgang aufweist, der darin besteht, die sich zwischen der zylindrischen Oberfläche des Barrens (1) und der Ablösungstiefe befindende Werkstoffschicht (2) mit einer Flüssigphasenabscheidung oder mit einer Gasphasenabscheidung zu bedecken.

12. Verfahren nach einem der vorhergehenden Ansprüche,
**dadurch gekennzeichnet, dass** der Werkstoff Silicium ist.

13. Verfahren nach einem der vorhergehenden Ansprüche, **dadurch gekennzeichnet, dass** die Atomarten Wasserstoffionen enthalten.

14. Verfahren nach Anspruch 13, **dadurch gekennzeichnet, dass** die Atomarten Dotierungsionen wie Phosphor oder Arsen enthalten.

15. Verfahren nach einem der vorhergehenden Ansprüche,
**dadurch gekennzeichnet, dass** es Vorgänge aufweist, die darin bestehen, durch Laminieren zwischen Walzen eine Schicht (6, 12) auf jede der Seiten der sich zwischen der zylindrischen Oberfläche des Barrens (1) und der Ablösungstiefe befindenden Werkstoffschicht (2) zu übertragen.

16. Verfahren nach einem der vorhergehenden Ansprüche, **dadurch gekennzeichnet, dass** es einen Vorgang aufweist, der darin besteht, mindestens eine Schaltkreismuster enthaltende Schicht (6, 12) auf die sich zwischen der zylindrischen Oberfläche des Barrens (1) und der Ablösungstiefe befindende Werkstoffschicht (2) zu übertragen.

17. Verfahren nach einem der vorhergehenden Ansprüche, **dadurch gekennzeichnet, dass** der Barren (1) einen kreisförmigen Querschnitt hat.

18. Verfahren nach einem der vorhergehenden Ansprüche,
**dadurch gekennzeichnet, dass** der Barren (1) einen quadratischen Querschnitt hat.

19. Vorrichtung zur Herstellung von Substraten, insbesondere für die Optik, die Elektronik oder die Optoelektronik, die
- Einrichtungen zur Implantierung (110) von Atomarten unter die Oberfläche eines Werkstoffs (1) in einer um einen bestimmten Wert herum verteilten Implantierungstiefe,
- Ablöseeinrichtungen (210, 310) zur Ablösung einer Werkstoffschicht (2) in Höhe einer sich in der Nähe der Implantierungstiefe befindenden Ablösungstiefe, aufweist,
**dadurch gekennzeichnet, dass** sie außerdem Dreheinrichtungen (410) zur Drehung eines zylindrischen Barrens (1) des Werkstoffs um eine Achse parallel zur zylindrischen Oberfläche des Barrens (1) aufweist.

20. Vorrichtung nach Anspruch 19, **dadurch gekennzeichnet, dass** sie Halteeinrichtungen (310) der sich zwischen der zylindrischen Oberfläche des Barrens (1) und der Ablösungstiefe befindende Werkstoffschicht (2) zur Aufnahme der Schicht (2) nach ihrem Lösen vom Barren (1) aufweist.

21. Vorrichtung nach Anspruch 20, **dadurch gekennzeichnet, dass** die Halteeinrichtungen (310) mehrere auf Walzenantriebseinrichtungen (316, 317) verteilte Unterdruck-Greifeinrichtungen (315) aufweist.
